# EUROPEAN PATENT SPECIFICATION

(11) **EP 2 170 020 B1**
(45) Date of publication and mention of the grant of the patent: **08.06.2011**
(21) Application number: 09012287.0
(22) Date of filing: 28.09.2009
(51) Int. Cl.: H05G 2/00, G03F 7/20

(54) **Extreme ultraviolet light source device and method for generating extreme ultraviolet radiation**
Lichtquellenvorrichtung für extremes Ultraviolettlicht und Verfahren zur Erzeugung einer extremen Ultraviolettstrahlung
Source lumineuse d'ultraviolets extrêmes et procédé pour générer un rayonnement UV extrême

(30) Priority: 29.09.2008 JP 2008249574
(43) Date of publication of application: 31.03.2010
(73) Proprietor: USHIO DENKI KABUSHIKI KAISHA, Tokyo 100 (JP)
(72) Inventor: Teramoto, Yusuke, Gotenba-shi Shizuoka-ken (JP); Mizokoshi, Hiroshi, Gotenba-shi Shizuoka-ken (JP); Yokoyama, Takuma, Gotenba-shi Shizuoka-ken (JP)
(74) Representative: Tomerius, Isabel

(56) References cited:
- EP-A- 1 976 344
- WO-A-03/087867
- US-A1- 2004 108 473
- US-A1- 2008 116 400

## Description

The present invention relates to an extreme ultraviolet light source device which can produce extreme ultraviolet radiation from a plasma produced by a discharge, and a method for generating extreme ultraviolet radiation, in particular the invention relates to an extreme ultraviolet light source device which can produce extreme ultraviolet radiation from a plasma produced by a discharge from a high-temperature plasma raw material after evaporation and a method for generating extreme ultraviolet radiation.

With the micro-miniaturisation and increasing integration of semiconductor integrated circuits, there is a requirement for improving the resolution of projection lithography apparatus used for their fabrication. In order to meet this requirement, the wavelengths of lithography light sources are being increasingly shortened and extreme ultraviolet light source devices (hereinafter called EUV light source device) are being developed which emit extreme ultraviolet radiation (hereinafter called EUV (extreme ultraviolet) radiation) at wavelengths of 13-14 nm, in particular at the 13.5 nm wavelength, as the new generation of light sources, following excimer lasers, for the exposure of semiconductors.

Although various methods of generating EUV radiation in EUV light source device are known, one of these is a method whereby a high-temperature plasma is produced by heating and excitation of a EUV radiating species and the EUV radiation emitted from this plasma is extracted.

Extreme ultraviolet light source devices using such a method can be roughly divided in a LPP (laser produced plasma) type EUV light source device and a DPP (discharge produced plasma) type EUV light source device.

The LPP type EUV light source device uses EUV radiation emitted from a high-temperature plasma produced by irradiating a solid, liquid or gaseous target with a pulsed laser. On the other hand, the DPP type EUV light source device uses EUV radiation emitted from a high-temperature plasma produced by inducing an electric current.

In both said types of EUV light source device, Xe (xenon) ions having a valence of approximately 10 are known at the present time as raw material for high-temperature plasma for generating EUV radiation, i.e. types of radiation emitting EUV radiation at the 13.5 nm wavelength, but attention is being paid to Li (lithium) ions and Sn (tin) ions as raw materials for high-temperature plasma in order to obtain higher emission intensity. For example, Sn has a conversion efficiency several times higher than that of Xe, this being the ratio of the EUV radiation emission intensity at the 13.5 nm wavelength to the input energy producing the high temperature plasma.

The mechanism of EUV emission based on the DPP method is explained briefly hereinafter.

In the DPP method, for example, a gaseous high-temperature plasma source environment is created inside a discharge chamber having electrodes disposed inside thereof and an initial plasma is produced by generating a discharge in the electrode gap in said environment. The ion density in the initial plasma is, for example, 10¹⁶ cm⁻³ and the electron temperature is, for example, less than 1 eV.

In this case, said initial plasma can be constricted by the action of a self-induced magnetic field of the current flowing in the electrode gap due to the discharge. As a result, the density of the initial plasma becomes high and the plasma temperature rises rapidly. This action is called hereinafter the pinch effect. The ion density of the plasma which has acquired a high temperature as a result of heating due to the pinch effect is 10¹⁷-10²⁰ cm⁻³, the electron temperature reaches around 20-30 eV and EUV radiation is emitted from this high-temperature plasma.

Recently, a method was proposed in JP-A-2007-505460 and corresponding US 2007/0090304 A1 whereby, in the DPP method, solid or liquid Li supplied to the electrode surface at which the discharge is produced is irradiated by an energy beam such as a laser beam and evaporated, and a high-temperature plasma is then produced by the discharge. The case where the energy beam is a laser is explained hereinafter. Said method is abbreviated as LAGDPP (laser assisted gas discharge produced plasma).

The EUV light source device shown in JP-A-2007-505460 and corresponding US 2007/0090304 A1 is explained hereinafter. A schematic diagram of the EUV light source device disclosed in said document is shown in Fig. 9.

Disk-shaped electrodes 14, 16 are disposed in a discharge space 12 which is adjusted to a specific pressure. The electrodes 14 and 16 are mutually spaced apart at a fixed gap in a predefined region 18 and are rotated about an axis of rotation 46.

Reference numeral 24 is the raw material for the high-temperature plasma which emits EUV radiation at the 13.5 nm wavelength. The high-temperature plasma raw material 24 is a heated metal melt and is contained in a container 26. The temperature of the metal melt 24 is adjusted by temperature adjustment means 30 provided inside the container 26.

Said electrodes 14, 16 are positioned so that part thereof dips into the container 26 holding the metal melt 24. The liquid metal melt 24 spread over the surface of the electrodes 14, 16 is transferred to the surface of said region 18 as a result of the rotation of the electrodes 14, 16. The metal melt 24 transferred to the surface of said region 18 (that is, the metal melt 24 present on the surface of the electrodes 14, 16 mutually spaced apart by a fixed gap in said region 18) is irradiated by a laser 20 from a laser source not shown in the diagram. The metal melt 24 irradiated by the laser 20 evaporates.

As a result of applying a pulsed voltage to the electrodes 14, 16 under conditions where the metal melt 24 has evaporated as a result of irradiation by the laser 20, a pulsed discharge is initiated in the region 18 and a plasma 22 is generated. When the plasma 22 is heated and excited and its temperature increased as a result of the high current flowing during the discharge, EUV radiation is generated from this high-temperature plasma. The EUV radiation is extracted from the top in the drawing.

That is to say, in the LAGDPP method reported in said JP-A-2007-505460 and corresponding US 2007/0090304 A1, a solid or liquid target (high-temperature plasma raw material) is irradiated by a laser and a gaseous high-temperature plasma raw material environment (initial plasma) is produced by evaporation of the raw material. As in the DPP method, the ion density in the initial plasma is, for example, 10¹⁶cm⁻³, and the electron temperature for example is less than 1 eV. Subsequently, as a result of heating due to driving of the discharge current, the ion density of the plasma which has acquired a high temperature reaches 10¹⁷-10²⁰ cm⁻³, the electron temperature reaches about 20-30 eV and EUV radiation is emitted from this high-temperature plasma. That is to say, the heating due to the discharge current driving in the LAGDPP method reported in JP-A-2007-505460 and corresponding US 2007/0090304 A1 uses the pinch effect as in the DPP method.

Moreover, 48 is a capacitor bank corresponding to the power source and is connected electrically to the metal melt 24 contained in the container 26 via an insulating feed line 50. Since the metal melt 24 is conductive, electrical energy is supplied to the electrodes 14, 16 partly dipping into the metal melt 24 from the capacitor bank 48 via the metal melt 24.

According to this method, Sn and Li which are solid at room temperature are readily evaporated in the vicinity of the discharge zone wherein the discharge is produced. That is to say, since evaporated Sn and Li can be supplied more efficiently to the discharge zone, EUV radiation at the 13.5 nm wavelength can be efficiently extracted after the discharge.

The EUV light source device reported in JP-A-2007-505460 and corresponding US 2007/0090304 A1 has the following advantages since the electrodes are made to rotate. Solid or liquid high-temperature plasma raw material comprising new high-temperature plasma raw material of the EUV generation type can usually be supplied to the discharge zone. Since the position irradiated by the laser and the position at which the high-temperature plasma is generated (discharge position) on the electrode surface are usually varied, the thermal loading on the electrodes is reduced and their consumption can be prevented.

However, the construction of the apparatus such as that shown in JP-A-2007-505460 and corresponding US 2007/0090304 A has the following problems.

According to said EUV light source device, as specified above, raw material on the electrode surface is evaporated by laser radiation, a discharge is initiated in the electrode gap and plasma is formed. However, in order to carry out the production of EUV radiation more efficiently, the gas density of the evaporated plasma raw material (for example, tin) supplied to the discharge zone must be to some extent high. This is because, as has been stated, the ion density of the high-temperature plasma from which EUV radiation is emitted is 10¹⁷-10²⁰ cm⁻³ and the ion density of the initial plasma before this high-temperature plasma is pinched must be around 10¹⁶ cm⁻³.

That is to say, if the gas density of the plasma raw material supplied to the discharge zone is lower than 10¹⁶ cm⁻³, for example, even if a discharge has been initiated, EUV radiation at the 13.5 nm wavelength is not generated from the plasma produced by the discharge.

In the EUV light source device in JP-A-2007-505460 and corresponding US 2007/0090304 A1, the gas of the plasma raw material is supplied to the gap between two electrodes (discharge gap) by irradiating liquid or solid raw material applied to the surface of the electrodes by means of a laser. However, the raw material evaporated by the laser irradiation spreads three-dimensionally in the gap between the two electrodes. As a result, it is difficult to control the gas density of the plasma raw material supplied to the discharge zone and the gas density when the spreading raw material gas reaches the opposed electrodes and the discharge is initiated is not necessarily suitable for EUV radiation.

The present invention has taken note of the information as presented above and the object of the present invention is to propose an EUV light source device and a method for generating EUV radiation whereby the (gas) density of the plasma raw material in the discharge zone can be appropriate.

In the present invention the aforesaid object is achieved by the extreme ultraviolet light source device as claimed in claim 1 and the method of generating EUV radiation according to claim 5. Preferred embodiments and method variants are described in the respective subclaims.

In an extreme ultraviolet light source device provided with a pair of mutually disposed discharge electrodes, pulsed power supplying means adapted to supply pulsed power to said discharge electrodes, raw material supplying means adapted to supply liquid or solid raw material onto said electrodes in order to cause extreme ultraviolet radiation to be emitted at said discharge electrodes, and energy beam means adapted to irradiate the raw material supplied to said discharge electrodes for generating a discharge in the gap between said pair of discharge electrodes by said raw material being evaporated, and a control part, said energy beam means is comprised of a first energy beam irradiation means adapted to radiate a first energy beam onto said raw material supplied onto said discharge electrodes for causing said raw material to evaporate, and a second energy beam means adapted to irradiate a second energy beam for further evaporating the raw material, wherein said control part controls said first energy beam irradiation means such that said first energy beam is radiated towards said raw material, and controls the second energy beam irradiation means such that the second energy beam is radiated during the time after the irradiation with said first energy beam and before the initiation of the discharge between said discharge electrodes.

In said extreme ultraviolet light source device, the pair of electrodes suitably are disk electrodes which are adapted to move rotationally so that the discharge generation position on the electrode surface varies.

In a preferred embodiment of the extreme ultraviolet light source device of the invention, the second energy beam irradiation means is adapted so that irradiation with the second energy beam takes place within 300 nanoseconds after said first energy beam irradiation.

In a method for generating extreme ultraviolet radiation in said extreme ultraviolet light source device of the invention, there is provided a first step wherein pulsed power is supplied to a pair of discharge electrodes onto which a liquid or solid raw material was applied in order for extreme ultraviolet radiation to be emitted, a second step wherein a first energy beam irradiation means is controlled by a control part, a first energy beam is radiated to the raw material on the electrode surface to which said pulsed power is supplied and causes said raw material to evaporate, and a third step wherein a second energy beam irradiation means is controlled by a control part, said second energy beam irradiation means is operated during the time after irradiation of said first energy beam, before the discharge is initiated in the gap between said pair of discharge electrodes, the raw material in the region irradiated by said first energy beam is irradiated by the second energy beam and the raw material is further evaporated.

In said method, said third step is carried out within 300 nanoseconds after said second step.

In the present invention, the following effects can be achieved.
Although the discharge in the discharge gap can be initiated by raw material which has been evaporated by irradiation of the first energy beam, by irradiating the same zone as has been irradiated with the first energy beam with a second energy beam in the interval after irradiation of the first energy beam until a discharge is initiated in the discharge electrode gap, a high density plasma raw material gas can be supplied to the discharge zone.
Moreover, by appropriately fixing the timing of the second energy beam irradiation, the density of the plasma raw material gas supplied to the discharge zone can be controlled so that it is suitable for EUV radiation. As a result, EUV radiation can be obtained more efficiently.

The invention will be explained in further detail with reference to the drawings. These drawings are schematic and merely illustrate a preferred embodiment of the invention without restricting the invention to same.
- Figure 1: is a cross-sectional front view of the EUV light source device according to an exem- plary embodiment of the invention.
- Figure 2: is a cross-sectional top view of the EUV light source device according to the exem- plary embodiment of Fig. 1.
- Figure 3: is a diagram showing an example of the focusing of the first and second laser.
- Figure 4: is a flow chart showing the operation of the exemplary embodiment shown in Figs. 1 and 2.
- Figure 5: is a timing chart explaining the formation of EUV radiation in the present invention.
- Figure 6: is a diagram showing an example of the emission of EUV radiation and the variation of the capacitor voltage when a second laser irradiation is carried out after the first la- ser irradiation.
- Figure 7: is a diagram showing the variation in the conversion efficiency of the emitted EUV radiation and the interval between the first laser irradiation and the second laser.
- Figure 8: is a diagram explaining the morphology of the plasma formed in the electrode gap.

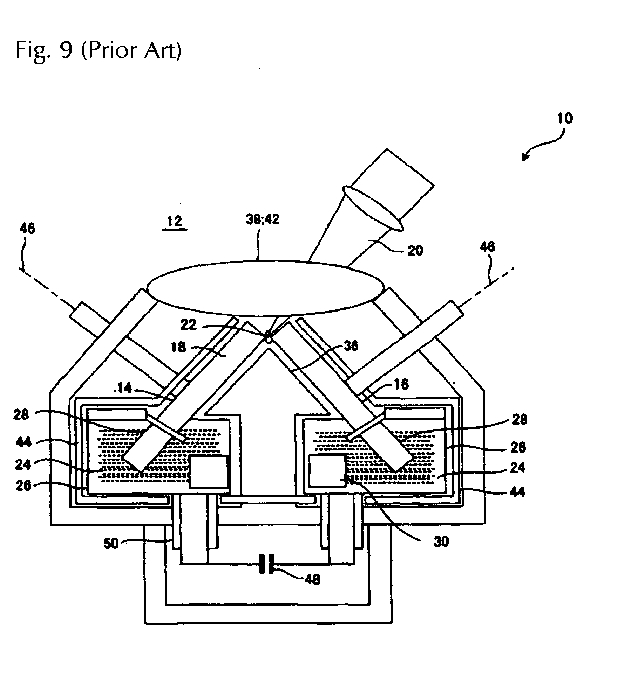

- Figure 9: shows an example of the construction of a conventional EUV light source device.

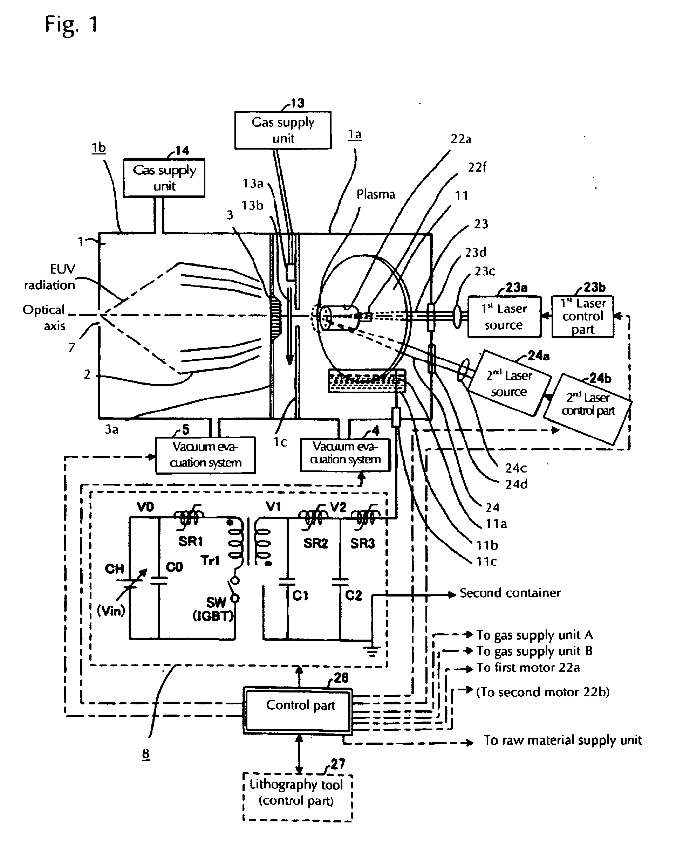

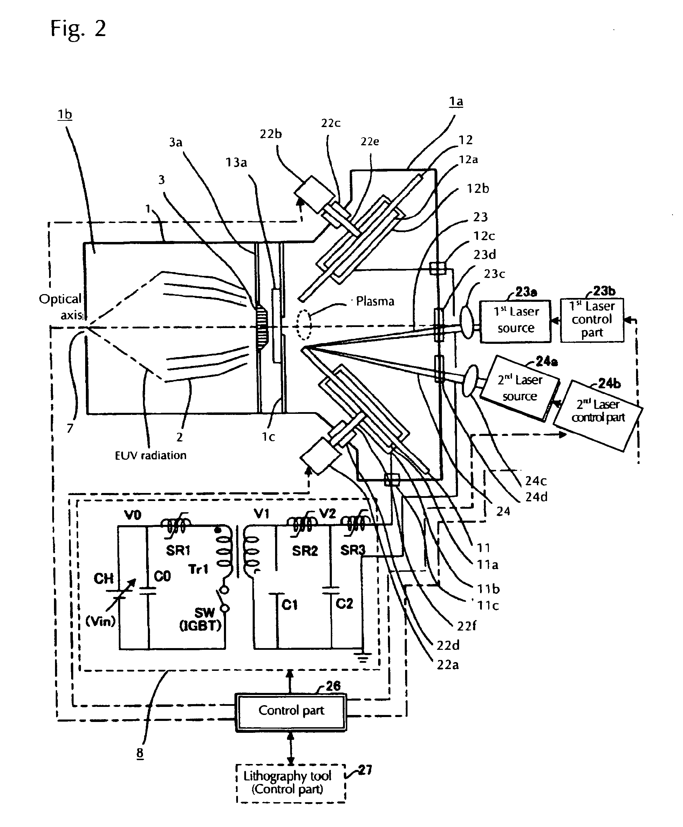

Figures 1 and 2 show sectional views of the structure of the extreme ultraviolet (EUV) light source device of an exemplary embodiment of the present invention. Figure 1 shows a front view of the EUV light source device of this exemplary embodiment where the EUV radiation can be extracted from the top left in this drawing. Figure 2 shows a top view of the EUV light source device of this exemplary embodiment.

The EUV light source device shown in Fig. 1 and Fig. 2 has a chamber 1 which is the discharge chamber. The chamber 1 can be largely divided into two spaces by means of a dividing wall 1c having an opening. The discharge part is located in one space. The discharge part comprises heating and excitation means which heats and excites high-temperature plasma raw material containing EUV radiating species. The discharge part is constructed from a pair of electrodes 11, 12.

In the other space, EUV collector optics 2 are provided which collect the EUV radiation extracted from the high temperature plasma produced by heating and exciting the high-temperature plasma raw material and pass it from the EUV radiation extraction part 7 provided in the chamber 1 to the illumination optical system of a lithography tool not shown in the drawing and a debris trap is provided to prevent debris produced as a result of the plasma generation by the discharge from being transferred to the EUV collector optics. In this exemplary embodiment, the debris trap as shown in Figs. 1 and Fig. 2 is constructed from a gas curtain 1 3b and a foil trap 3.

Hereinafter, the space in which the discharge part is located is designated as discharge space 1a and the space where the EUV collector optics are located is designated as collecting space 1b.

A vacuum evacuation system 4 is connected to the discharge space 1a and a vacuum evacuation system 5 is connected to the collecting space 1 b. Moreover, the foil trap 3 is held inside the collecting space 1 b of the chamber 1 by means of a foil trap holding partition wall 3a. That is to say, in the example shown in Figs. 1 and 2 the collecting space 1b is divided into a further two spaces by the foil trap holding partition wall 3a.

In Figs. 1 and 2, the discharge part is shown as larger than the EUV collector optics part but this is for ease of understanding and the actual size relationship is not as shown in Figs. 1 and 2. In practice, the EUV collector optics part is larger than the discharge part. That is to say, the collecting space 1 b is larger than the discharge space 1 a.

The various parts of the EUV light source device of the present exemplary embodiment and their operation are explained hereinafter.

### DISCHARGE PART

The discharge part consists of a first discharge electrode 11 which is a disk-shaped member made of metal and a second discharge electrode 12 which is likewise a disk-shaped member made of metal. The first and second discharge electrodes 11, 12 are, for example, made of a high melting point metal such as tungsten, molybdenum, tantalum etc. and are positioned mutually facing one another at a specified distance apart. In this case, one of the two electrodes 11, 12 is the ground side electrode and the other is the high-voltage side electrode.

Although the surfaces of the two electrodes 11, 12 may well be positioned in the same plane, it is desirable if the edge portions of the peripheral parts where the electric field is concentrated during application of the power are positioned so that they are mutually facing at a specified distance apart. That is to say, the electrodes are preferably positioned so that the imaginary planes containing the electrode surfaces intersect. Said specified distance is the distance in the part where the distance between the edge portions of the peripheral parts of the electrodes is the shortest.

As discussed subsequently, a discharge is produced in the edge portions of said peripheral parts when a pulsed power is applied to the two electrodes 11, 12 from a pulsed power supply means. In general, discharges are produced in the part where the distance between the edge portions of the peripheral parts of the two electrodes 11, 12 is the shortest. Hereinafter, the space where the discharge is generated between the two electrode is called the discharge zone.

If the edge parts of the peripheral portions of the electrodes 11, 12 are positioned mutually facing one another at a specified distance apart, as described above, when viewed from above as in Fig. 2, the two electrodes are positioned radially centered on the position where the imaginary planes containing the surfaces of the first and second discharge electrodes intersect. In Fig. 2 when the part where the distance between the edge portions of the peripheral parts of the two radially positioned electrodes is the greatest is centered at the position of intersection of said imaginary planes, it is positioned so that it is on the opposite side to the aforesaid EUV collector optics.

The EUV light source device in the present exemplary embodiment uses EUV radiation emitted from a high-temperature plasma generated by discharge current driving of a high-temperature plasma raw material evaporated by laser irradiation. The means for heating and excitation of the high-temperature plasma raw material comprises a high current due to a discharge generated in the gap between the pair of electrodes 11, 12. Thus, the electrodes 11, 12 are subjected to a large thermal loading accompanying the discharge. In addition, since the high-temperature plasma is generated in proximity to the discharge electrodes, the electrodes 11, 12 are also exposed to thermal loading from this plasma. As a result of this thermal loading, the electrodes gradually become worn and metal debris is produced.

When the EUV light source device is used as a light source device for exposure devices, the EUV radiation emitted from the high-temperature plasma is focused by a condensing lens 2 and this focused EUV radiation is emitted towards the exposure device. The metal debris causes damage to the EUV collector optics 2 and the reflection efficiency of the EUV radiation in the EUV collector optics 2 deteriorates.

Furthermore, since the electrodes 11, 12 gradually become worn, the shape of the electrodes changes. As a result, the discharge produced in the gap between the pair of electrodes 11, 12 gradually becomes unstable and in consequence, the generation of EUV radiation also becomes unstable.

When the EUV light source device is used as a light source of a lithography tool for semiconductor mass production, it is necessary to suppress wear of the electrodes as specified above and lengthen the electrode lifetime as far as possible.

In order to meet these requirements, in the EUV light source device shown in Figs. 1 and 2, the first electrode 11 and the second electrode 12 are configured to be disk-shaped and are constructed to rotate at least during the discharge. That is to say, since the first electrode and the second electrode 11, 12 are made to rotate, the position at which the pulsed discharge is generated in the two electrodes varies per pulse. Thus, the thermal loading on the first and the second electrodes 11, 12 is reduced, wear spots on the electrodes 11, 12 are reduced and a long electrode lifetime can be achieved. Hereinafter, the first electrode 11 is designated as first rotating electrode and the second electrode 12 is designated as second rotating electrode.

In practice, the axis of rotation 22e of the first motor 22a and the axis of rotation 22f of the second motor 22b are attached to the respective central parts of the disk-shaped first rotating electrode 11 and the second rotating electrode 12. The first rotating electrode 11 and the second rotating electrode 12 are rotated as a result of the first motor 22a and the second motor 22b being rotated about their respective axes of rotation 22e, 22f. The directions of rotations are not specifically controlled. In this case, the axes of rotation 22e, 22f, for example, are introduced into the chamber 1 via mechanical seals 22c, 22d. The mechanical seals 22c, 22d permit rotation of the axes of rotation whilst maintaining a reduced-pressure atmosphere inside the chamber 1.

As shown in Fig. 1, the first rotating electrode 11 and the second rotating electrode 12 are positioned in such a manner that part thereof is immersed in molten tin 11a, 12a inside a first container 11b and a second container 12b. In addition to forming raw material for the high-temperature plasma which emits EUV radiation at the 13.5 nm wavelength, this tin 11a, 12a acts as metal for the supply of electricity for supplying power to the first rotating electrode 11 and the second rotating electrode 12.

The first container 11 b and the second container 12b are connected to a power generator 8 comprising a pulsed power supply means via insulating power introducing parts 11c, 12c such that a reduced-pressure atmosphere can be maintained inside the chamber 1. The first and second containers 11b, 12b and the tin 11 a, 12a are conductive and since part of the first rotating electrode 11 and part of the second rotating electrode 12 are immersed in said tin 11 a, 12a, a pulsed power is applied from the pulsed power generator 8 in the gap between the first container 11 b and the second container 12b and as a result, a pulsed power is applied in the gap between the first rotating electrode 11 and the second rotating electrode 12.

Although not shown in the drawing, temperature control means are provided in the first container 11 b and the second container 12b for maintaining the tin in the molten state.

### RAW MATERIAL SUPPLY MEANS

The first container 11b and the second container 12b form the raw material supply means for supplying the tin 11a, 12a forming the raw material for the high-temperature plasma to the surface of the first rotating electrode 11 and the second rotating electrode 12.

As stated above, the first rotating electrode 11 and the second rotating electrode 12 are positioned in such a manner that parts (peripheral parts) thereof are immersed in said containers containing molten tin. Inside said containers 11b, 12b tin 11a, 12a is applied to the peripheral surface of the electrodes. The tin 11a, 12a applied to the electrodes is transferred to the discharge zone as a result of the rotation of the electrodes.

The tin 11a, 12a which has been transferred to the discharge zone is irradiated by a laser and a discharge is initiated as a result of the tin 11a, 12b being evaporated.

Although the tin 11a, 12a applied to the electrode surfaces is consumed by means of the discharge, further tin 11a, 12a can be supplied to the electrode surfaces 11a, 12a by means of the rotation since they are immersed in the tin 11a, 12a inside the first container 11b and the second container 12b.

Although a container containing tin as specified above is used as the raw material supplying means in the present exemplary embodiment, it is also possible to use means where molten tin is dropped or made to flow into holes or grooves formed in the electrode surface.

### ENERGY BEAM IRRADIATION MEANS FOR EVAPORATING THE RAW MATERIAL

Two energy beam irradiation means, a first energy beam irradiation means and a second energy beam irradiation means, are provided as energy beam irradiation means for evaporating the raw material in the EUV light source device in the present exemplary embodiment.

The first energy beam irradiation means comprises a first laser source 23a which emits a first laser beam 23 and a first laser control part 23b which controls the operation of the said first laser source 23a.

The second energy beam irradiation means comprises a second laser source 24a which emits a second laser beam 24 and a second laser control part 24b which controls the operation of the said second laser source 24a.

As first and second laser sources 23a, 24a emitting first and second laser beams 23, 24, it is possible to use, for example, carbon dioxide laser sources, solid state laser sources, such as YAG lasers, YVO₄ lasers, YLF lasers and excimer lasers, such as ArF lasers, KrF lasers, XeCI laser etc.

In the present exemplary embodiment, the high-temperature plasma raw material can equally well be irradiated by ion beams and electron beams instead of laser beams, which although they emit energy beams similar to lasers, irradiate specific points in the discharge zone.

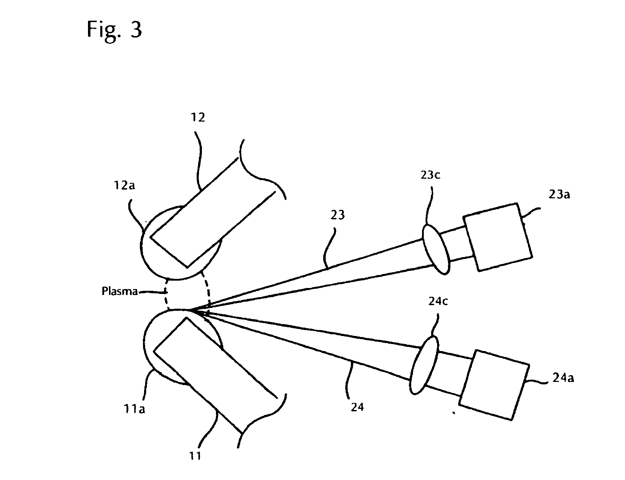

An example of the focusing of the first and second laser beams is shown in Fig. 3. This figure shows an enlarged part of the electrodes where the two laser beams from Fig. 2 are focused. As shown in the drawing, the laser beams are focused on the high-temperature plasma raw material (tin) on the first rotating electrode. A convex lens can be used, for example, as a focusing optical system.

As a result of focusing the laser beams on the high-temperature plasma raw material (tin) on the rotating electrode, the high-temperature plasma raw material (tin) evaporates. The evaporated gas soon reaches the oppositely disposed second rotating electrode and a discharge is initiated.

The high-temperature plasma raw material evaporated by the laser radiation propagates mainly in the direction of the normal to the surface of the laser-irradiated high-temperature plasma raw material. Therefore, the laser must irradiate on the side of the high-temperature plasma raw material facing the discharge zone so that after evaporation, the high-temperature plasma raw material propagates in the direction of the opposing electrode.

Included among the high-temperature plasma raw material after evaporation by the laser irradiation is some which has not contributed to the formation of the high-temperature plasma by the discharge, and some clusters of atomic gas which have formed by degradation as a result of the plasma formation and which come in contact with the low-temperature part inside the EUV light source device and accumulate as debris.

As a result, it is difficult for a laser to irradiate the high-temperature plasma raw material (tin) 21 in such a manner that after evaporation, the high-temperature plasma raw material does not propagate in the direction of the EUV collector optics.

The irradiation of the high-temperature plasma raw material (tin) 21 by the first laser beam 23 and the second laser beam 24 is carried out as follows.

Firstly, the high-temperature plasma raw material (tin) 21 which has been applied to the first electrode is irradiated with the first laser beam 23. The high-temperature plasma raw material which has evaporated as a result of the irradiation by the first laser beam 23 propagates mainly in the direction normal to the surface of the high-temperature plasma raw material which is irradiated by the first laser beam 23.

The high-temperature plasma raw material which has spread soon reaches the opposing first electrode and a discharge is initiated but before the high-temperature plasma raw material which has been evaporated as a result of irradiation by the first laser reaches the opposing second electrode, the high-temperature plasma raw material (tin) 21 is irradiated by the second laser beam 24 in the region which has been irradiated by the first laser beam 23.

### PULSED POWER GENERATOR

The pulsed power generator 8 comprising the pulsed power supply means applies pulsed power of short pulse width to the gap between the first rotating electrode 11 and the second rotating electrode 12, i.e. the first container 11b and the second container 12b which are the loads, via a magnetic pulse compression circuit consisting of a capacitor and magnetic switch.

Figures 1 and 2 show an example of the construction of a pulsed power generator.

The pulsed power generator in Figures 1 and 2 comprises a two-stage magnetic pulse compression circuit using two magnetic switches SR2, SR3 consisting of saturable inductors. The two-stage magnetic pulse compression circuit is formed by the capacitor C1, the first magnetic switch SR2, the capacitor C2 and a second magnetic switch SR3.

The magnetic switch SR1 is used to reduce the switching losses at the solid switch SW which is a semiconductor switching element such as an IGBT and is also known as a magnetic assist. Moreover, the solid switch SW forms the aforesaid switching means and is hereinafter called switching means.

The structure and operation of the circuit is explained hereinafter with reference to Figs. 1 and 2. Firstly, the charging voltage of the charger CH is adjusted to a fixed value Vin and the main capacitor C0 is charged by means of the charger CH. At this time, the solid switch SW such as an IGBT is off.

When charging of the main capacitor C0 is completed and the solid switch SW is on, the voltage applied to both terminals of the solid switch SW is applied mainly to both terminals of the magnetic switch SR1.

When the time integral of the charging voltage V0 of the main capacitor C0 applied to both terminals of the magnetic switch SR1 reaches a limiting value determined by the characteristic of the magnetic switch SR1, the magnetic switch SR1 saturates and the magnetic switch closes and current flows in the loop comprising main capacitor C0, magnetic switch SR1, primary side of the step-up transformer Tr1 and solid switch SW. At the same time, current flows in the loop comprising the secondary side of the step-up transformer Tr1 and the capacitor C1, and the charge which has accumulated in the main capacitor C0 is transferred and charges the capacitor C1.

Thereafter, when the time integral of the voltage V1 in the capacitor reaches a limiting value determined by the characteristic of the magnetic switch SR2, the magnetic switch SR2 saturates and the magnetic switch closes and current flows in the loop comprising the capacitor C1, the magnetic switch SR2 and the capacitor C2, and the charge which has accumulated in the capacitor C1 is transferred and charges the capacitor C2.

Again after this, when the time integral of the voltage V2 in the capacitor C2 reaches a limiting value determined by the characteristic of the magnetic switch SR3, the magnetic switch SR3 saturates and the magnetic switch closes and a high-voltage pulse is applied to the first rotating electrode and the second rotating electrode, i.e. to the first container and the second container.

In this case, by fixing the inductance of the capacity transfer circuit of each stage which is formed by the magnetic switches SR2, SR3 and capacitors C1, C2, such that it becomes smaller on going over to subsequent stages, a pulse compression operation is carried out such that the pulse width of the current pulse flowing in each stage becomes successively narrower, a short-pulse high-intensity discharge can be achieved in the gap between the first rotating electrode and the second rotating electrode and the input power to the plasma can be increased.

### EUV COLLECTOR OPTICS PART

The EUV radiation emitted from the discharge part is collected by grazing-incidence EUV collector optics 2 provided in the EUV collector optics part and is transferred from the EUV radiation extraction part 7 provided in the chamber 1 to an illumination optical system of a lithography tool not shown in the figure.

The grazing-incidence EUV collector optics 2 are generally formed by a plurality of thin concave mirrors positioned in a nested manner with high precision. The shape of the reflecting surface of each concave mirror is, for example, an ellipsoid of revolution, a parabola of revolution, or Wolter shaped, and each concave mirror is a solid of revolution. In the present case, the light reflection surfaces are concave shapes consisting, in order from the light incidence side, of a hyperbola of revolution, an ellipsoid of revolution, or a hyperbola of revolution and a parabola of revolution.

The base material of said concave mirrors is nickel (Ni). Since EUV radiation of an extremely short wavelength is emitted, the reflecting surfaces of the concave mirrors are constructed as extremely good smooth surfaces. The reflecting material applied to this smooth surface is, for example, a layer of metal such as ruthenium (Ru), molybdenum (Mo), or rhodium (Rh). The reflecting surface of each concave mirror is coated with such a metal layer with a high degree of precision.

As a result of being constructed in this manner, the EUV condensing lens can efficiently reflect and collect EUV radiation at angles of incidence of 0° to 25°.

### DEBRIS TRAP

A debris trap is provided between the said discharge part and said EUV collector optics part in order to transmit only EUV radiation and prevent damage to the EUV collector optics 2 by capturing debris such as metal dust produced by sputtering of the peripheral parts of the first and second rotating electrodes 11, 12 in contact with the high-temperature plasma produced after the discharge by said high-temperature plasma and debris attributable to Sn and Li which are EUV radiating species in the high-temperature plasma raw material.

As stated above the debris trap is formed by a gas curtain 13b and a foil trap 3 in the present exemplary embodiment of the EUV light source device shown in Figs. 1 and 2.

The gas curtain 13b is formed by gas supplied inside the chamber 1 via a nozzle 13a from a gas supply unit 13.

The structure of the gas curtain is shown in Fig. 1. The nozzle 13a is rectangular parallelepiped shaped and the opening through which gas is discharged is a long narrow square shape. When gas is supplied to the nozzle 13a from the gas supply unit 13, gas is discharged as a jet from the opening in the nozzles 13a and a gas curtain 13b is formed. The gas curtain 13b changes the direction of propagation of said debris and prevents debris from reaching the EUV collector optics 2. In this case, the gas used for the gas curtain 13b is preferably a gas having a transmissivity to EUV radiation, for example, inert gases such as helium (He) and argon (Ar) and hydrogen (H₂) can be used.

A foil trap 3 is further provided between the gas curtain 13b and the EUV collector optics 2. The foil trap 3 is constructed of a plurality of plates positioned in the radial direction of the high-temperature plasma formation zone and a ring-shaped support for supporting these plates in order to shield the EUV radiation emitted from the high-temperature plasma.

When such a foil trap 3 is provided between the gas curtain 13b and the EUV collector optics 2, the pressure between the high-density high-temperature plasma and the foil trap 3 increases. When the pressure increases, the gas density of the gas curtain provided at this location increases and collisions between gas atoms and debris increase. Since the debris undergoes repeated collisions, the kinetic energy decreases. Thus, the energy during collisions of debris with the EUV collector optics is reduced and damage to the EUV collector optics can be reduced.

It is also advantageous to introduce buffer gas not connected with the emission of the EUV radiation by connecting a gas supply unit 14 to the side of the collecting space 1 b in the chamber 1. The buffer gas supplied from the gas supply unit 14 is passed from the side of the EUV collector optics 2 through the foil trap 3, via the space between the foil trap holding partition wall 3a and the partition wall 1c and is evacuated from the vacuum evacuation device 4. By producing such a flow of gas, debris which has not been captured by the foil trap 3 is prevented from flowing to the side of the EUV collector optics 2 and damage to the EUV collector optics 2 caused by debris can be reduced.

Moreover, in addition to buffer gas it is also advantageous to supply halogen gas such as chlorine (Cl₂) and hydrogen radicals to the collecting space from the gas supply unit 14. These gas act as cleaning gases by reacting with debris which has accumulated at the EUV collector optics 2 without being removed by the debris trap and removing said debris. Thus, the reduction in performance involving a reduction in the reflectivity of the EUV collector optics as a result of the accumulation of debris can be suppressed.

### PARTITION WALL

The pressure of the discharge space 1a is fixed so that a discharge can be favourably produced to heat and excite the high-temperature plasma raw material evaporated by laser irradiation of the raw material and a vacuum must be maintained at a certain level below atmospheric pressure.

On the other hand, since the kinetic energy of the debris at the debris trap must be low, the collecting space 1 b must be maintained at a specified pressure in the debris trap part.

In Figs. 1 and 2, a specific gas flows from the gas curtain, and by maintaining a specific pressure at the foil trap 3, the kinetic energy of the debris is low. As a result, a reduced pressure atmosphere at a pressure of several 100 Pa must be maintained in the collecting space.

In the EUV light source device of the present invention, a partition wall 1c is provided to divide the interior of the chamber 1 into a discharge space and a collecting space. An opening is provided in the partition wall 1c to spatially connect both spaces. Since the opening functions as a pressure reducing means, the discharge space 1a can be maintained at several Pa and the collecting space 1b can be maintained at a suitable pressure by making suitable allowance for the evacuation performance of the vacuum evacuation device, the size of the opening and the gas flow from the gas curtain 13b whilst respectively evacuating the vacuum space with the vacuum evacuation device 4 and the collecting space with the vacuum evacuation device 5.

### OPERATION OF THE EXTREME ULTRAVIOLET (EUV) LIGHT SOURCE DEVICE

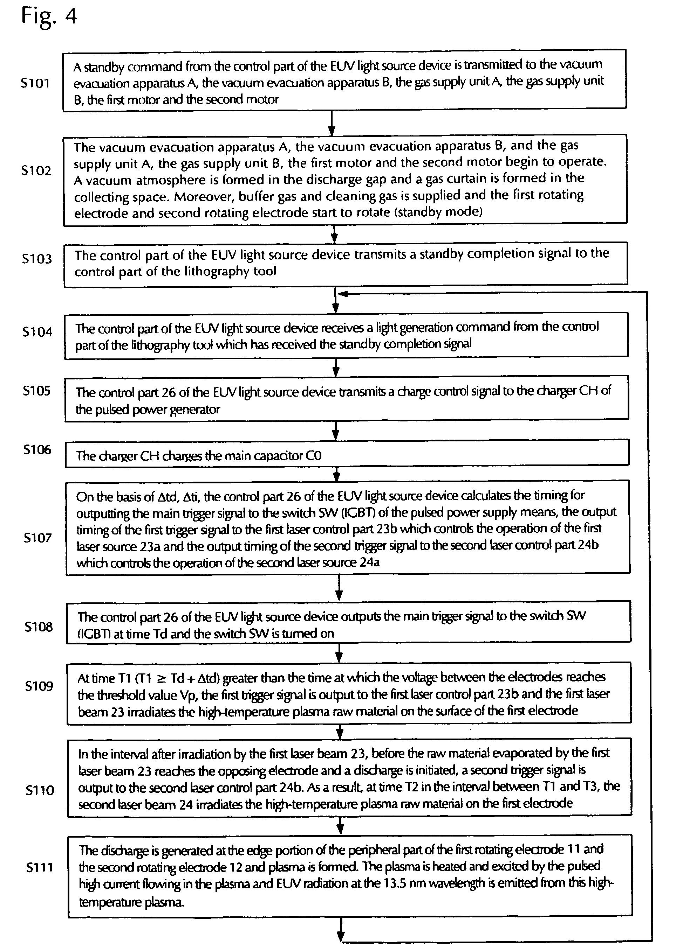

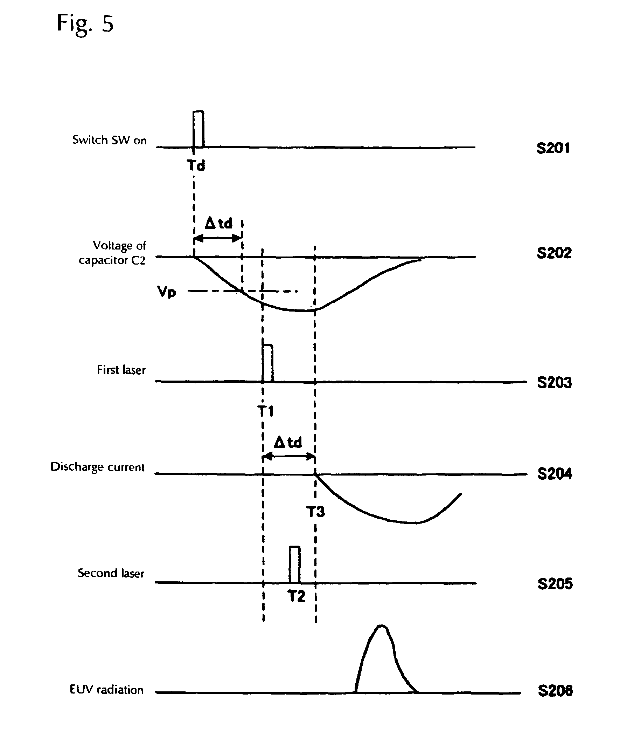

When the EUV light source device of the present exemplary embodiment is used as a lithography light source, it operates for example as follows. Figure 4 is a flow chart showing the operation of this exemplary embodiment, Fig. 5 is a timing chart to explain the method of generating EUV radiation and the operation of this exemplary embodiment is explained hereinafter with reference to Fig. 4 and Fig. 5.

The control part 26 of the EUV light source device holds in memory the time data Δtd, Δti shown in Fig. 5.

Here Δtd is the time from the time (time Td) at which a trigger signal is input to the switch SW (for example, IGBT) forming the switching means of the pulsed power supply means (pulsed power generator 8) until the voltage of the capacitor C2 with the switch SW in the ON state reaches the threshold value Vp. Δti is the time after irradiation of the high-temperature plasma raw material on the electrode with the first laser beam before the evaporated raw material reaches the opposing electrode and a discharge current flows (a discharge is initiated).

Moreover, the threshold value Vp is the value of the voltage when the discharge current flowing after the discharge has been produced exceeds the threshold value Ip. The threshold value Ip is the lower limit of the discharge current required to produce a high-temperature plasma which emits EUV radiation of the desired intensity.

In general, when the voltage V applied to the discharge electrodes 11, 12 is high, the rise of the voltage waveform in the discharge gap is fast. Thus, said Δtd is dependent on the voltage V applied to the discharge electrodes 11, 12. The control part 26 of the EUV light source device holds in memory the relationship between the time Δtd and the voltage V obtained in previous experiments, for example, as a table.

Firstly, a standby command from the control part of the EUV light source device is transmitted to the vacuum evacuation apparatus 5, the vacuum evacuation apparatus 4, the gas supply unit 13, the gas supply unit 14, the first motor 22a and the second motor 22b (S101 in Fig. 4).

The vacuum evacuation apparatus 5, the vacuum evacuation apparatus 4, and the gas supply unit 13, the gas supply unit 14, which have received the standby command, begin to operate. That is, the vacuum evacuation apparatus 4 operates and a vacuum atmosphere is formed in the discharge gap. Moreover, at the same time as the vacuum evacuation apparatus 5 comes into operation, the gas supply unit 13 comes into operation, forming the gas curtain 13b and the gas supply unit 14 comes into operation and supplies the buffer gas and cleaning gas inside the collecting space 1b. As a result, the collecting space 1b reaches a specific pressure. In addition, the first motor 22a and the second motor 22b come into operation, and the first rotating electrode 11 and second rotating electrode 12 rotate. Hereinafter, said operating mode is called in general terms standby mode (S102 in Fig. 4).

The control part 26 of the EUV light source device transmits a standby completion signal to the control part 27 of the lithography tool (S103 in Fig. 4).

The control part 26 of the EUV light source device receives a light generation command from the control part 27 of the lithography tool which has received the standby completion signal. When the lithography tool side controls the intensity of the EUV emission, EUV emission intensity data are also included in said light generation command (S104 in Fig. 4).

The control part 26 of the EUV light source device transmits a charge control signal to the charger CH of the pulsed power generator 8. The charge control signal, for example, consists of a discharge initiation timing data signal. As specified above, if EUV emission intensity data are included in the light generation command from the control part 27 of the lithography tool, the charging voltage data signal to the main capacitor C0 is also included in said charge control signal.

For example, the relationship between the EUV emission intensity and the charging voltage to the main capacitor C0 can be determined experimentally in advance and a table giving the relationship between the two can be compiled. The control part 26 of the EUV light source device holds this table in its memory and on the basis of the EUV emission intensity data contained in the light generation command received from the control part 27 of the lithography tool, charging voltage data for the main capacitor C0 are called up from the table. Then, on the basis of the called-up charging voltage data, the control part 26 of the EUV light source device transmits a charging control signal containing the charging voltage data signal to the main capacitor C0 to the charger CH of the pulsed power generator (S105 in Fig. 4).

The charger CH charges the main capacitor C0 as described above (S106 in Fig. 4).

On the basis of the pre-memorised time data Δtd, Δti, the control part 26 of the EUV light source device calculates the timing for outputting the main trigger signal to the switch SW (IGBT) of the pulsed power supply means, the output timing of the first trigger signal to the first laser control part 23b which controls the operation of the first laser source 23a and the output timing of the second trigger signal to the second laser control part 24b which controls the operation of the second laser source 24a (S107 in Fig. 4).

Taking as a reference the time Td at which the main trigger signal is input to the switching means of the pulsed power generating means (pulsed power generator 8) and the switch SW (IGBT) is in, the control part 26 advantageously predetermines the time T1 for irradiation by the first laser beam 23 and the time T2 for irradiation by the second laser beam 24.

The control part 26 outputs the main trigger signal to the switch SW (IGBT) at time Td and the switch SW closes (S108 in Fig. 4, S201 in Fig. 5).

When the switch SW is closed, the voltage in the gap between the first rotating electrode 11, and the second rotating electrode 12 rises after the time Δtd, the voltage of the capacitor C2 reaches the threshold value Vp (S202 in Fig. 5).

As stated above, the threshold value Vp is the value of the voltage when the discharge current flowing after the discharge has been produced exceeds the threshold value Ip, where the threshold value Ip is the lower limit of the discharge current required to produce a high-temperature plasma which emits EUV radiation of the desired intensity.

At time T1 (T2 ≥ Td + Δtd) greater than the time at which the voltage of the capacitor C2 reaches the threshold value Vp, the first trigger signal is output to the first laser control part 23b and the first laser beam 23 irradiates the high-temperature plasma raw material on the surface of the first electrode (S109 in Fig. 4, S203 in Fig. 5).

The first laser beam 23 irradiates the high-temperature plasma raw material on the discharge electrode and the high-temperature plasma raw material evaporates. This evaporated high-temperature plasma raw material propagates three-dimensionally mainly in the direction of the normal to the surface of the high-temperature plasma raw material irradiated by the first laser beam 23. After time Δti, the spreading high-temperature plasma raw material reaches the opposing second electrode and at time T3 (T1 + Δti) a discharge is initiated in the gap between the pair of electrodes and a discharge current flows (S204 in Fig. 5).

In the interval after irradiation by the first laser, before the raw material evaporated by the first laser beam 23 reaches the opposing electrode and a discharge is initiated, a second trigger signal is output to the second laser control part 24b. As a result, at time T2 in the interval between T1 and T3, the second laser beam 24 irradiates the high-temperature plasma raw material on the first electrode (S110 in Fig. 4, S205 in Fig. 5). The irradiation position of the second laser beam 24 is adjusted so that the region irradiated by the first laser can be reproducibly irradiated.

Although the raw material on the electrode again evaporates and begins to spread as a result of the irradiation by the second laser, before the raw material evaporated as a result of irradiation by the second laser reaches the opposing electrode (whilst the evaporated raw material is still propagating), the raw material evaporated by the irradiation of the first laser reaches the opposing electrode and a discharge is thus initiated between both electrodes.

The discharge is generated in the edge portion of the peripheral part of the first rotating electrode 11 and the second rotating electrode 12. When the plasma is heated and excited and raised to a high temperature by the pulsed high current flowing in the plasma, EUV radiation at a wavelength of 13.5 nm is emitted from this high-temperature plasma (step S111 in Fig. 4, S206 in Fig. 5).

As a result of the magnetic forces of the discharge, the raw material which has been evaporated by the irradiation of the second laser beam is compressed whilst still propagating and a small-diameter high-density plasma is formed. In consequence, EUV radiation having a high conversion efficiency is emitted.

When the first EUV emission has ended as described above, the system then returns to step S104 in Fig. 4 and awaits a light generation command from the lithography tool.

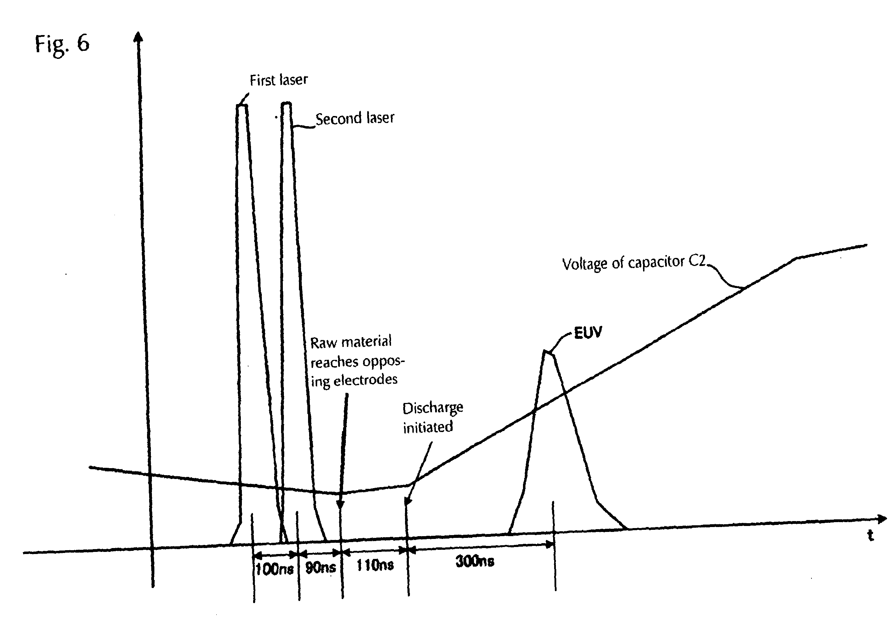

Figure 6 shows an example of the emission of EUV radiation and the variation of the voltage of the capacitor C2 of the pulsed power generator when irradiation by the second laser beam was carried out after the irradiation by the first laser beam. In this figure the time (nanoseconds: ns) is plotted on the abscissa and arbitrary units are plotted on the ordinate. Since a high negative voltage is applied to the discharge gap, the voltage is higher with decreasing ordinate and lower with increasing ordinate.

In this drawing, after the tin on the electrode has been irradiated by the first laser beam 23 for 100 ns, the same part that has been irradiated by the first laser beam 23 is irradiated by the second laser beam 24. Approximately 300 ns after the irradiation by the first laser beam 23, a discharge is initiated and current flows in the discharge gap and the voltage of the capacitor C2 decreases. The emission of EUV radiation occurs approximately 600 ns after irradiation by the first laser beam 23.

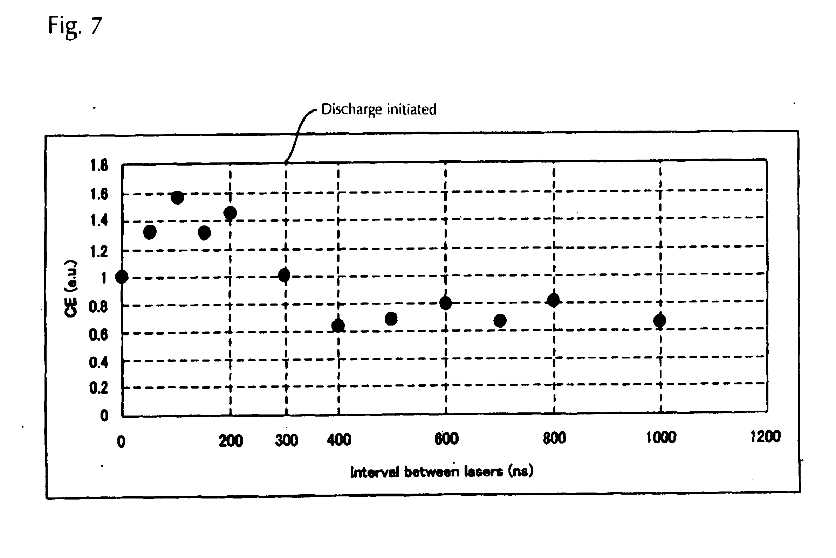

Figure 7 shows the conversion efficiency of the emitted EUV radiation as a function of the time interval between the first laser beam and the second laser beam. In this diagram the time is plotted in the abscissa (ns) and the ordinate gives the conversion efficiency. In this diagram the conversion efficiency when the irradiation of the first laser beam and the irradiation of the second laser beam is simultaneous is shown as 1. The conversion efficiency is the value obtained by dividing the energy of the EUV radiation emitted from the plasma by the energy used in the discharge in the electrode gap.

The irradiation energy of the first and second laser beams is approximately 100 ml in each case.

As stated above, the discharge is initiated approximately 300 ns after the irradiation of the first laser beam. As shown in Fig. 7, compared to the case where the irradiation of the first laser beam and the irradiation of the second laser beam is carried out simultaneously, the conversion efficiency of the emission of EUV radiation increases when the irradiation of the high-temperature plasma raw material by the second laser beam is carried out in the interval up to 300 ns from the irradiation by the first laser beam, i.e. before the discharge is initiated.

When the irradiation by the second laser is approximately at the same time as the initiation of the discharge, the conversion efficiency is approximately the same as when the irradiation of the first and second laser is simultaneous.

However, if the irradiation by the second laser is carried out after the initiation of the discharge (greater than 300 ns), the conversion efficiency conversely decreases.

Thus, EUV emission having a good conversion efficiency compared with the irradiation of the first laser can be achieved by irradiation with the second laser in the internal between irradiation of the first laser and initiation of the discharge in the electrode gap.

Since the optimum timing of the second laser irradiation varies according to the magnitude of the pulsed power applied to the electrodes and the electrode gap, the optimum timing is determined by preliminary experiments and fixed.

In addition, the radiation intensity (energy) of the first laser beam 23 and the radiation intensity (energy) of the second laser beam 24 are suitably determined including the magnitude of the energy, whether the energies are both of the same magnitude or whether they are different.

In addition, the focal point of the first laser beam 23 and the focal point of the second laser beam 24 are also suitably determined.

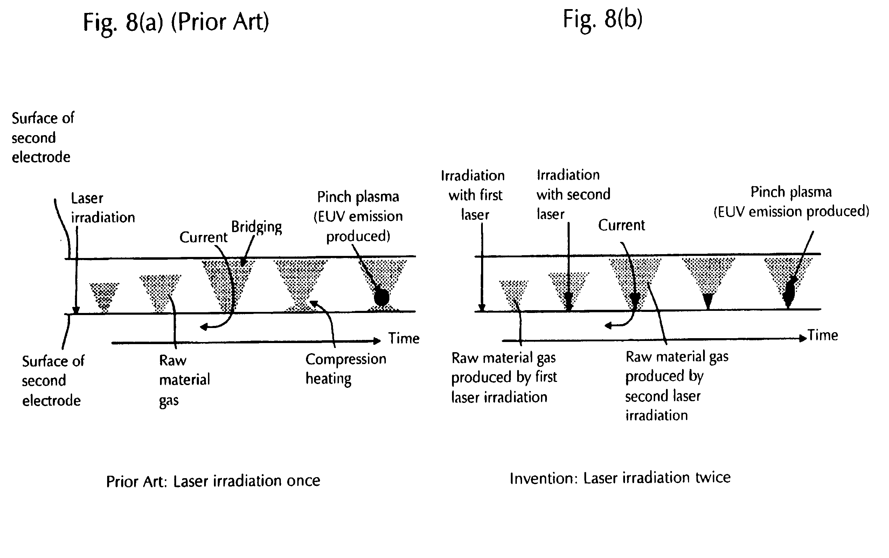

Figure 8 is a diagram explaining the morphology of the plasma generated in the electrode gap. This diagram shows the surface of a pair of vertically opposed discharge electrodes and shows how the plasma morphology in the discharge gap typically varies with time.

Figure 8(a) shows the conventional case where laser irradiation has only been carried out once and Figure 8(b) shows the case of the invention where laser irradiation is carried out twice.

In the conventional Fig. 8(a), when the high-temperature plasma raw material (tin) on the electrode is laser irradiated, the raw material gas produced by the laser irradiation propagates and reaches the opposing electrode, current begins to flow, bridging the electrode gap and a discharge is initiated.

The raw material gas is compression heated due to the magnetic forces with increasing discharge current and a pinch plasma is formed. EUV radiation is emitted from this pinch plasma.

However, since the raw material gas progresses to the opposing electrode and expands in the transverse direction before the discharge is initiated, at the time of discharge initiation the gas has spread substantially and the gas density is low. As a result, the pinch efficiency deteriorates and the resulting ion density and electron temperature do not attain values at which emission of EUV radiation can be achieved with a high conversion efficiency.

In contrast, in Figure 8(b) according to the invention, although the high-temperature plasma raw material (tin) on the electrode is irradiated by the first laser and the raw material gas produced by the irradiation with the first laser spreads and reaches the opposing electrode, current begins to flow, bridging the electrode gap, and a discharge is initiated as in the case of said conventional Figure 8(a), before the raw material gas produced by the irradiation with the first laser bridges the discharge gap and the discharges is initiated, the high-temperature plasma raw material (tin) on the electrode is irradiated by the second laser (in the region irradiated by the first laser). As a result, raw material gas is again produced in the discharge gap.

Although the discharge is excited by the raw material gas produced by the first laser irradiation, at the time point when this discharge is initiated, the raw material gas produced by the second laser irradiation is present in the electrode gap with a high gas density, i.e. does not expand as much three-dimensionally since not much time has elapsed after the second laser irradiation.

Thus, when the raw material gas is compression heated by means of the magnetic forces as the discharge current increases, the pinch efficiency increases and the resulting ion density and electron temperature attain values at which EUV radiation can be emitted with a high conversion efficiency.

## Claims

1. An extreme ultraviolet light source device comprising
- a pair of mutually opposed discharge electrodes (11, 12),
- pulsed power supplying means (8) adapted to supply pulsed power to said discharge electrodes,
- raw material supplying means (11b, 12b) for supplying liquid or solid raw material to said electrodes in order to cause extreme ultraviolet radiation to be emitted at said discharge electrodes, and
- energy beam irradiation means (23a, 24a) adapted to emit an energy beam (23, 24) for irradiating the raw material supplied to said discharge electrodes in order to initiate a discharge in the gap between said pair of discharge electrodes by said raw material being evaporated, and a control part (26)
**characterised in that**
said energy beam irradiation means is comprised of
- a first energy beam irradiation means (23a) adapted to emit a first energy beam for irradiating said raw material supplied to said discharge electrodes and causing said raw material to evaporate, and
- a second energy beam irradiation means (24a) adapted to emit a second energy beam for irradiating the raw material in the region irradiated by said first energy beam for further evaporating the raw material, wherein
said control part (26) controls said first energy beam irradiation means (23a) such that said first energy beam is radiated towards said raw material, and
controls the second energy beam irradiation means (24a) such that the second energy beam is radiated during the time after the irradiation with said first energy beam and before the initiation of the discharge between said discharge electrodes (11, 12).

2. The extreme ultraviolet light source device according to claim 1, **characterised in that** said discharge electrodes are disk-like electrodes adapted to move rotationally so that the discharge generation position on the electrode surface varies.

3. The extreme ultraviolet light source device according to claim 1 or 2, **characterised in that** said second energy beam irradiation means is adapted to emit the second energy beam within 300 nanoseconds after said first energy beam emission.

4. The extreme ultraviolet light source device according to any one of claims 1 to 3, **characterised in that** said first and second energy beam irradiation means are laser light sources.

5. A method for generating extreme ultraviolet radiation using the extreme ultraviolet light source device according to any one of claims 1 to 4,
**characterised in comprising**
- a first step wherein pulsed power is supplied to the pair of discharge electrodes (11, 12) supplied with a liquid or solid raw material in order for extreme ultraviolet radiation to be emitted,
- a second step wherein a first energy beam irradiation means is controlled by a control part (26), a first energy beam is radiated to the raw material on the electrode surface to which said pulsed power is supplied and causes said raw material to evaporate, and
- a third step wherein a second energy beam irradiation means is controlled by a control part (26), said second energy beam irradiation means is operated during the time after emission of said first energy beam and in the interval before the discharge is initiated in the gap between said pair of discharge electrodes (11, 12), the raw material in the region irradiated by said first energy beam is irradiated by the second energy beam and the raw material is further evaporated.

6. The method for generating extreme ultraviolet radiation according to claim 5, **characterised in that** said third step is carried out within 300 nanoseconds after said second step.

## Patentansprüche

1. Extrem-Ultraviolett-Lichtquellenvorrichtung umfassend:
- ein Paar einander gegenüber liegende Entladungselektroden (11, 12),
- gepulste Energieversorgungsmittel (8), die dazu ausgebildet sind, gepulste Energie an die Entladungselektroden zu liefern,
- Rohmaterialversorgungsmittel (11b, 12b) zur Versorgung der Elektroden mit flüssigem oder festem Rohmaterial, um die Emission von Extremultraviolettstrahlung an den Entladungselektroden zu verursachen, und
- Mittel (23a, 24a) zum Ausstrahlen von Energiestrahlen, die dazu ausgebildet sind, einen Energiestrahl (23, 24) zur Bestrahlung des an die Entladungselektroden gelieferten Rohmaterials auszusenden, um eine Entladung im Spalt zwischen dem Paar Entladungselektroden durch Verflüchtigung des Rohmaterials einzuleiten, und ein Steuerungsteil (26),
**dadurch gekennzeichnet, dass**
die Mittel zum Ausstrahlen von Energiestrahlen folgendes umfassen:
- ein erstes Mittel (23a) zum Ausstrahlen von Energiestrahlen, das dazu ausgebildet ist, einen ersten Energiestrahl zur Bestrahlung des an die Entladungselektroden gelieferten Rohmaterials auszusenden und das Verflüchtigen des Rohmaterials zu verursachen, und
- ein zweites Mittel (24a) zum Ausstrahlen von Energiestrahlen, das dazu ausgebildet ist, einen zweiten Energiestrahl zur Bestrahlung des Rohmaterials in dem Bereich, der durch den ersten Energiestrahl bestrahlt wurde, zur weiteren Verflüchtigung des Rohmaterials auszusenden, wobei
das Steuerungsteil (26) das erste Mittel (23a) zum Ausstrahlen von Energiestrahlen derart steuert, dass der erste Energiestrahl zum Rohmaterial hin ausgestrahlt wird, und
das zweite Mittel (24a) zum Ausstrahlen von Energiestrahlen derart steuert, dass der zweite Energiestrahl in der Zeit nach der Bestrahlung mit dem ersten Energiestrahl und vor dem Einleiten der Entladung zwischen den Entladungselektroden (11, 12) ausgestrahlt wird.

2. Extrem-Ultraviolett-Lichtquellenvorrichtung nach Anspruch 1,
**dadurch gekennzeichnet, dass**
die Entladungselektroden scheibenförmige Elektroden sind, die dazu ausgebildet ist, Rotationsbewegungen auszuführen, so dass die Position an der Oberfläche der Elektroden, in der die Entladung erzeugt wird, variiert.

3. Extrem-Ultraviolett-Lichtquellenvorrichtung nach Anspruch 1 oder 2,
**dadurch gekennzeichnet, dass**
das zweite Mittel zum Ausstrahlen von Energiestrahlen dazu ausgebildet ist, den zweiten Energiestrahl innerhalb von 300 Nanosekunden nach dem Aussenden des ersten Energiestrahls auszusenden.

4. Extrem-Ultraviolett-Lichtquellenvorrichtung nach einem der Ansprüche 1 bis 3,
**dadurch gekennzeichnet, dass**
die ersten und die zweiten Mittel zum Ausstrahlen von Energiestrahlen Laserlichtquellen sind.

5. Verfahren zur Erzeugung von Extremultraviolettstrahlung unter Verwendung der Extremultraviolett-Lichtquellenvorrichtung nach einem der Ansprüche 1 bis 4,
**dadurch gekennzeichnet, dass** es umfasst:
- einen ersten Schritt, bei dem gepulste Energie an das mit einem flüssigen oder festen Rohmaterial versorgte Paar Entladungselektroden (11, 12) geliefert wird, um Extremultraviolettstrahlung auszusenden,
- einen zweiten Schritt, bei dem ein erstes Mittel zum Ausstrahlen von Energiestrahlen durch ein Steuerungsteil (26) gesteuert wird, ein erster Energiestrahl auf das Rohmaterial an der mit der gepulsten Energie versorgten Elektrodenoberfläche ausgestrahlt wird und das Verflüchtigen dieses Rohmaterials verursacht, und
- einen dritten Schritt, bei dem ein zweites Mittel zum Ausstrahlen von Energiestrahlen durch das Steuerungsteil (26) gesteuert wird, das zweite Mittel zum Ausstrahlen von Energiestrahlen in der Zeit nach dem Aussenden des ersten Energiestrahls und in dem Zeitintervall vor dem Einleiten der Entladung im Spalt zwischen dem Paar Entladungselektroden (11, 12) betrieben wird, das Rohmaterial in dem durch den ersten Energiestrahl bestrahlten Bereich durch den zweiten Energiestrahl bestrahlt wird und das Rohmaterial weiter verflüchtigt wird.

6. Verfahren zur Erzeugung von Extremultraviolettstrahlung nach Anspruch 5,
**dadurch gekennzeichnet, dass**
der dritte Schritt innerhalb von 300 Nanosekunden nach dem zweiten Schritt ausgeführt wird.

## Revendications

1. Dispositif de source lumineuse dans l'ultraviolet extrême comprenant:
- une paire d'électrodes de décharge (11, 12) opposées l'une à l'autre,
- des moyens d'alimentation en énergie en impulsions (8) adaptés pour fournir de l'énergie en impulsion aux dites électrodes de décharge,
- des moyens d'apport de matière première (11b, 12b) pour fournir une matière première liquide ou solide aux dites électrodes afin de provoquer l'émission de rayonnement ultraviolet extrême au niveau desdites électrodes de décharge, et
- des moyens d'irradiation par un faisceau d'énergie (23a, 24a) adaptés pour émettre un faisceau d'énergie (23, 24) pour irradier la matière première fournie aux dites électrodes de décharge afin de déclencher une décharge dans l'espace compris entre ladite paire d'électrodes de décharge par l'évaporation de ladite matière première, et une partie de commande (26), **caractérisé en ce que** ledit moyen d'irradiation par un faisceau d'énergie se compose de:
- un premier moyen d'irradiation par un faisceau d'énergie (23a) adapté pour émettre un premier faisceau d'énergie pour irradier ladite matière première fournie aux dites électrodes de décharge et provoquer l'évaporation de ladite matière première, et
- un deuxième moyen d'irradiation par un faisceau d'énergie (24a) adapté pour émettre un deuxième faisceau d'énergie pour irradier la matière première dans la région irradiée par ledit premier faisceau d'énergie pour faire évaporer davantage la matière première,
dans lequel ladite partie de commande (26) commande ledit premier moyen d'irradiation par un faisceau d'énergie (23a) de telle façon que ledit premier faisceau d'énergie soit émis vers ladite matière première et commande le deuxième moyen d'irradiation par un faisceau d'énergie (24a) de telle façon que ledit deuxième faisceau d'énergie soit émis pendant le temps suivant l'irradiation par ledit premier faisceau d'énergie et avant le déclenchement de la décharge entre lesdites électrodes de décharge (11, 12).

2. Dispositif de source lumineuse dans l'ultraviolet extrême selon la revendication 1,
**caractérisé en ce**
**que** lesdites électrodes de décharge sont des électrodes en forme de disques adaptées pour se déplacer en rotation de telle façon que la position de génération de la décharge à la surface des électrodes varie.

3. Dispositif de source lumineuse dans l'ultraviolet extrême selon la revendication 1 ou 2,
**caractérisé en ce**
**que** ledit deuxième moyen d'irradiation par un faisceau d'énergie est adapté pour émettre le deuxième faisceau d'énergie dans les 300 nanosecondes suivant l'émission dudit premier faisceau d'énergie.

4. Dispositif de source lumineuse dans l'ultraviolet extrême selon l'une quelconque des revendications 1 à 3,
**caractérisé en ce**
**que** lesdites premier et deuxième moyens d'irradiation par un faisceau d'énergie sont des sources de lumière laser.

5. Procédé pour produire un rayonnement ultraviolet extrême à l'aide du dispositif de source lumineuse dans l'ultraviolet extrême selon l'une quelconque des revendications 1 à 4,
**caractérisé en ce**
**qu'**il comprend:
- une première étape dans laquelle de l'énergie en impulsions est fournie à la paire d'électrodes de décharge (11, 12) alimentée en une matière première solide ou liquide afin qu'un rayonnement ultraviolet extrême soit émis,
- une deuxième étape dans laquelle un premier moyen d'irradiation par un faisceau d'énergie est commandé par une partie de commande (26), un premier faisceau d'énergie est émis vers la matière première sur la surface de l'électrode à laquelle ladite énergie en impulsions est fournie et fait évaporer ladite matière première, et
- une troisième étape dans laquelle un deuxième moyen d'irradiation par un faisceau d'énergie est commandé par une partie de commande (26), lequel deuxième moyen d'irradiation par un faisceau d'énergie est activé pendant le temps suivant l'émission dudit premier faisceau d'énergie et dans l'intervalle précédant le déclenchement de la décharge dans l'espace entre ladite paire d'électrodes de décharge (11, 12), la matière première dans la région irradiée par le premier faisceau d'énergie est irradiée par le deuxième faisceau d'énergie est la matière première est encore évaporée.

6. Procédé pour produire un rayonnement ultraviolet extrême selon la revendication 5,
**caractérisé en ce**
**que** ladite troisième étape est exécutée dans les 300 nanosecondes suivant ladite deuxième étape.
